# EUROPÄISCHE PATENTSCHRIFT

(11) **EP 0 502 385 B1**
(45) Veröffentlichungstag und Bekanntmachung des Hinweises auf die Patenterteilung: **21.06.1995**
(21) Anmeldenummer: 92102989.8
(22) Anmeldetag: 22.02.1992
(51) Int. Cl.: C23C 16/50, C23C 16/40, C23C 14/50, C23C 14/20, C08J 7/04, G02B 1/10

(54) **Verfahren zur Herstellung einer doppelseitigen Beschichtung von optischen Werkstücken**
Process for the double-sided coating of optical workpieces
Procédé pour la production d'un revêtement bilatéral sur les pièces optiques

(30) Priorität: 05.03.1991 CH 659/91
(43) Veröffentlichungstag der Anmeldung: 09.09.1992
(73) Patentinhaber: BALZERS AKTIENGESELLSCHAFT, 9496 Balzers (LI)
(72) Erfinder: Zimmermann, Heinrich, Dr., CH-9470 Buchs (CH); Zucchi, Mauro, CH-9478 Azmoos (CH)

(56) Entgegenhaltungen:
- FR-A- 2 169 072
- FR-A- 2 176 019
- US-A- 3 713 869
- US-A- 4 512 284

## Beschreibung

Die vorliegende Erfindung betrifft ein Verfahren zum Beschichten mindestens eines um eine Achse rotierenden Werkstückes in einer Vakuumkammer mittels einer Plasmaentladung zur Abscheidung einer Polymerisatschicht und durch thermisches Verdampfen sowie eine Beschichtungsvorrichtung zur Beschichtung mindestens eines Werkstückes.

Solche Schichten finden insbesondere Verwendung im ophthalmischen Bereich. In diesem Anwendungsbereich werden die Schichten besonders harten Umweltbedingungen ausgesetzt. Schichten wie beispielsweise Antireflexschichten müssen deshalb besonders gut auf der Unterlage haften. Zu diesem Zweck ist es bekannt, dass bevor die thermisch aufgedampfte optisch wirksame Schicht oder das Schichtsystem aufgebracht wird, das Substrat mit einer Zwischenschicht als Haftvermittler versehen werden, oder angeätzt werden muss. Die erwähnte Haftschicht darf die optischen Eigenschaften des Schichtsystems und der Linse nicht beeinträchtigen. Sie muss insbesondere transparent sein. Besondere Bedeutung hat diese Haftschicht bei der Beschichtung von Kunststoffsubstraten.

Es ist bekannt, solche Schichten aus einer Glimmentladung mit Hilfe polymerisierbarer Gase abzuscheiden. Dieser Vorgang ist in der Fachwelt als Glimmpolymerisation bekannt. Aus der US-Patentschrift 3,713,869 ist bekannt, eine Zwischenschicht als Haftvermittler auf ein PMMA-Kunststoffsubstrat abzuscheiden und anschliessend eine harte anorganische Schicht aufzudampfen. Aus dem Artikel "Antireflection coating prepared by plasma polymerization of perfluorobutene-2" von T. Wydeven und R. Kubacki, aus Applied Optics, Volume 15, Nr. 1, Januar 1976, ist ein Verfahren zur Herstellung einer Antireflexionsbeschichtung mittels Plasmapolymerisation beschrieben. Es wird auch erwähnt, dass die Plasmaabscheidung gleichzeitig auf beiden Seiten des Substrates erfolgen kann. Die Offenlegungsschrift 22 63 480 beschreibt ein Plasmapolymerisationsabscheideverfahren bei welchem die Schicht als kratzfeste und wasserabweisende Schutzschicht vorgesehen ist.

Die vorliegende Erfindung bezweckt ein Verfahren bzw. eine Anordnung vorzuschlagen, mit welchem es möglich wird, Werkstücke beidseitig mit Plasmapolymerisationsschichten und thermisch aufgedampften optischen Schichten so zu versehen, dass eine hohe Beständigkeit der Beschichtung gewährleistet ist, bei grosser Wirtschaftlichkeit des industriellen Produktionsverfahrens.

Dies wird beim Verfahren genannter Art dadurch erreicht, dass es nach dem kennzeichnenden Teil von Anspruch 1 ausgeführt wird.

Die Erfindung geht von der an sich bekannten Erkenntnis aus, dass die Verwendung einer durch Plasmapolymerisation abgeschiedenen Haftschicht, für die nachfolgend aufgedampfte Schicht vorteilhafte Ergebnisse bringt. Das thermische Aufdampfen von optischen Schichten findet bekannterweise in Vakuumbedampfungsanlagen statt, wo wegen der geforderten hohen Beschichtungsgleichmässigkeit auf dem gesamten Werkstückträger dieser oft kalottenförmig ausgebildet ist und gleichzeitig während dem Aufdampfvorgang gedreht wird. Solche Aufdampfanlagen sind beispielsweise im Buch "Coatings on glass" von H.K. Pulker, Verlag Elsevier, 1984, Seite 213, beschrieben. Optische Gläser, wie beispielsweise Brillengläser, müssen aber beidseitig behandelt werden. Bei den Anlagen mit gebräuchlichen Glimmelektroden ist also die Behandlung zuerst auf einer Seite vorzunehmen, anschliessend das Werkstück zu drehen und dann die Behandlung auf der Rückseite vorzunehmen. Es hat sich nun aber gezeigt, dass vorerwähnte Substrate bei der Behandlung auf diese Weise, die nach dem Drehen des Werkstückes aufgebrachte Schicht, nicht dieselbe Qualität besitzen. Die auf der Rückseite aufgebrachte Schicht kann Risse zeigen, leicht abgerieben werden oder sogar abplatzen was zu einer völligen Unbrauchbarkeit der Beschichtung führt. Es wird nun erkannt, dass bei der ersten Plasmabehandlung die Rückseite des Werkstückes unzulässig kontaminiert wird. Um dies zu vermeiden, müsste die Rückseite während der Behandlung der Vorderseite vollständig abgedeckt sein. Es ist leicht ersichtlich, dass dies bei einem kommerziellen Produktionsverfahren zu sehr hohen Aufwendungen führt. Die Lösung dieses Problems kann durch Vorgehen nach Anspruch 1 erreicht werden. Die Plasmapolymerisationsschicht muss gleichzeitig und symmetrisch auf der Vorder- und Rückseite des Substrates abgeschieden werden. Dieses gleichzeitige Abscheiden auf beiden Seiten des Werkstückes ergibt die erwünschte Schichtqualität bei gleichzeitig hoher Prozessökonomie. Anschliessend wird dann die erste Seite durch thermisches Verdampfen beschichtet, die Anlage geflutet und geöffnet, das Werkstück gedreht, die Anlage wieder evakuiert um die zweite Seite zu beschichten.

Gemäss Vorgehen nach Anspruch 2 kann die Prozessökonomie weiter drastisch gesteigert werden. Ebenso erhöht sich damit die Prozesssicherheit beträchtlich. Das Oeffnen der Anlage, das Manipulieren am Werkstückträger und das anschliessende Abpumpen der Anlage um die nächsten Aufdampfschichten aufzubringen ist sehr zeitaufwendig und kann die wirtschaftliche Durchführung des Verfahrens in Frage stellen. Eine Oeffnung der Anlage zwischen den Aufdampfschritten kann ausserdem eine Verschiebung der Prozessbedingungen bewirken sowie Verschmutzungen und Partikel verursachen. Das Unterbrechen des Verfahrens und Oeffnen der Vakuumanlage hat somit neben wirtschaftlichen Nachteilen vor allem auch Nachteile bezüglich der Schichtqualität zur Folge. Eine höchst vorteilhafte Möglichkeit dieses Problem zu umgehen besteht darin, eine Werkstückhalterung zu verwenden, die automatisch gedreht werden kann nach Beendigung des Plasmapolymerisationsprozesses und der Beschichtung der ersten Seite, ohne Unterbrechung des Vakuums, um anschliessend die Rückseite des Werkstückes mittels thermischer Verdampfung zu beschichten.

Verschiedene optische Anwendungen erfordern ein sogenanntes Mehrfachschichtsystem. Ein solches Mehrfachschichtsystem kann sich beispielsweise so zusammensetzen, dass zuerst eine Polymerisatschicht auf dem Substrat abgeschieden wird und danach eine erste Aufdampfschicht aus einem bestimmten Material bestehend, worauf dann weitere Aufdampfschichten aus beispielsweise verschiedenen Materialien bestehend aufgebracht werden können. Auch kann es vorteilhaft sein, bei schwierigen Kombinationen von Aufdampfschichten eine weitere Zwischenschicht aus einem Polymerisat als Haftschicht abzuscheiden. Bei gewissen Anwendungen ist es weiterhin vorteilhaft, eine Polymerisatschicht als Deckschicht über den Aufdampfschichten anzubringen. In diesem Fall werden Polymerisatschichten mit wasserabstossender und abriebfester Wirkung als Schutzschicht verwendet. Mehrfachschichten solcher Art werden gemäss Vorgehen nach Anspruch 3 oder 4 vorteilhaft ausgebildet.

Für die Abscheidung der plasmapolymerisierten Schicht ist das Vorgehen und die Verwendung der Materialien nach Anspruch 5 besonders geeignet. Als Reaktionsgas werden Monomere verwendet, wie beispielsweise organische Verbindungen aus beispielsweise aromatischen und aliphatischen Kohlenwasserstoffen oder beispielsweise metallorganische Verbindungen wie beispielsweise aus siliziumorganischen Verbindungen.

Gemäss Vorgehen nach Anspruch 6 werden der Plasmaentladung neben dem Reaktionsgas für die Polymerisation zusätzlich Stützgase beigemischt. Besonders geeignet ist hierbei Sauerstoff, Argon oder auch Luft. Mit dieser Beimischung kann die gewünschte chemische Zusammensetzung des Reaktionsproduktes eingestellt werden.

Durch erfindungsgemässes Vorgehen kann weiterhin das Verfahren bezüglich Abscheidegeschwindigkeit wie auch Schichtzusammensetzung beeinflusst werden unter Zuhilfenahme von Magnetfeldern zur Beeinflussung respektive Erhöhung der Plasmadichte. Solche Magnetfelder können mit elektromagnetischen oder mit permanenten Magneten erzeugt werden. Diese magnetfelderzeugenden Mittel können sowohl innerhalb wie ausserhalb des Plasmareaktors angeordnet werden. Eine geeignete Wirkung wird dann erzielt, wenn die magnetische Flussdichte im Wirkungsbereich in der Nähe der Elektroden und des Substrates Werte von 50 bis 500 Gauss aufzeigen. Erfindungsgemäss zeichnet sich dieses Vorgehen nach Anspruch 7 aus.

Durch Vorgehen nach Anspruch 8 werden besonders günstige Ergebnisse durch das erfindungsgemässe Verfahren erreicht im Bereich der ophthalmischen Optik. Insbesondere die optische Beschichtung von Brillenglaslinsen muss hohen Anforderungen genügen bezüglich Haftfestigkeit, Beständigkeit und optischer Gleichförmigkeit.

Die erfolgreiche kommerzielle Realisierung des Verfahrens erfordert eine Anlagenkonfiguration, welche entsprechend horgfältig konzipiert ist. Eine solche Beschichtungsanlage muss bei hohem Durchsatzvermögen kostengünstig ausgeführt sein und gleichzeitig die hohen Schichtqualitäten ermöglichen. Es wurde nun weiterhin erkannt, dass das erfindungsgemässe Verfahren in einer allgemein üblichen Vakuumbeschichtungsanlage durch Ergänzen von prozessspezifischen Elementen ohne zusätzlichen grossen Aufwand realisiert werden kann. Die bislang auch geforderten hohen Schichtqualitäten ohne Polymerisatschicht wurden bisher durch Aufdampfen auf einen drehenden Werkstückhalter zur Erzeugung der Gleichförmigkeit der Schichtdicke erzeugt. Die Erweiterung der Anlage mit stab- oder flächenförmigen Glimmelektroden sowohl auf der Rückseite wie auf der Vorderseite der drehenden Werkstückhalterung ermöglicht erfindungsgemäss die Durchführung des Polymerisationsabscheideverfahrens gleichzeitig auf beiden Seiten der Werkstückhalterung sowie in einem weiteren Prozessschritt die Abscheidung der Aufdampfschichten. Ueberraschend hierbei ist, dass trotz der unsymmetrischen Formen der Werkstücke und der Werkstückhalterung und trotz der engen Verhältnisse auf der Vakuumwand zugewandten Seite der Werkstückhalterung die Plasmapolymerisationsschicht hinreichend gleichförmig bei sehr guter Qualität abgeschieden werden kann. Ein Vorgehen in der Realisierung der Anordnung nach Anspruch 9 ermöglicht das erfindungsgemässe Verfahren durchzuführen.

Das Plasmapolymerisationsverfahren und das unmittelbar darauf folgende Bedampfungsverfahren erfolgt mit demselben Werkstückhalter in der gleichen Vakuumkammer. Da sich die ganze Anordnung durch besondere Einfachheit auszeichnet, ist es aus Wirtschaftlichkeitsgründen nicht vorgesehen, die Elektroden für den Aufdampfvorgang mit Hilfe eines Manipulationsmechanismus zu entfernen. Beim Aufdampfvorgang wird ein Teil der Elektrode, welcher der Verdampfungsquelle ausgesetzt ist, beschichtet. Das Beschichtungsmaterial, welches auf die Elektrode abgeschieden wird, wird somit der Werkstückhalterung und den darauf befindlichen Werkstücken verlorengehen. Dies wird die Aufwachsrate während des Beschichtungsvorganges verringern. Werden stabförmige Elektroden verwendet, welche verhältnissmässig dünn sind, so sind die Verluste vernachlässigbar, bei grösserflächigen Elektroden steigen die Verluste durch Abschattung der Werkstücke entsprechend an, was das Verfahren unwirtschaftlich machen kann. Bei grösseren Elektrodenflächen kann allerdings der Polymerisationsvorgang mit höherer Rate ablaufen. Es gilt hierbei ein Optimum zu finden für die Dimensionierung der Grösse der abdeckenden Elektrodenfläche. Es hat sich gezeigt, dass gemäss Vorgehen nach Anspruch 11 gute Resultate zu erreichen sind. Eine Flächenabdeckung des Werkstückträgers durch die Elektroden von einigen Prozent ergibt sehr gute Ergebnisse, wobei Flächenabdeckungen von über 50% wirtschaftlich nicht mehr zu vertreten sind, obwohl die Schichtqualität ausreichend gut wäre.

Besonders gute Resultate beim Plasmapolymerisationsvorgang werden erreicht, wenn die Elektroden und die Zuleitungen gemäss Vorgehen nach Anspruch 12 abgeschirmt werden. Die Ausbreitung des Plasmas soll erfindungsgemäss gezielt auf den Werkstückträger begrenzt werden. Die Zuleitung soll vollständig isoliert und abgeschirmt werden, wobei hingegen die Elektroden nur auf der dem Werkstückträger abgewandten Seite isoliert oder abgeschirmt werden sollen. Das Vorgehen nach Anspruch 12 erhöht die Abscheiderate der Polymerisationsschicht sowie die Reproduzierbarkeit ganz beträchtlich und ist in vielen Fällen ausschlaggebend für die Verwendbarkeit des Verfahrens.

Die Erfindung wird anschliessend beispielsweise anhand von Figuren und Beispielen erläutert.

Die Figuren zeigen:
Figur 1:
   Eine Prozesskammer schematisch und im Querschnitt zur Durchführung eines Plasmapolymerisationsverfahrens und eines Aufdampfverfahrens.
Figur 2:
   Eine im Schnitt dargestellte stabförmige Elektrode mit Dunkelraumabschirmungen beidseitig der Werkstückhalterung angeordnet.
Figur 3:
   Eine im Schnitt dargestellte flächenförmige Elektrode mit Dunkelraumabschirmungen beidseitig der Werkstückhalterung angeordnet.

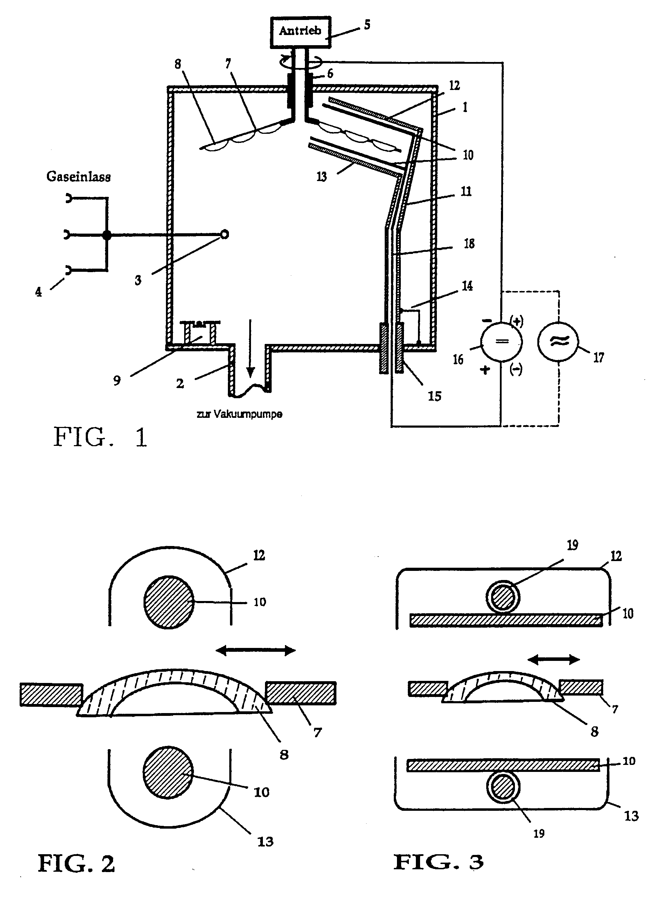

In Figur 1 ist im Querschnitt Prozesskammer 1 zur Erzeugung von aufgedampften Schichten gezeigt. Die Kammer 1 ist über einen Pumpstutzen 2 mit einer Vakuumpumpe verbunden. Die Werkstückhalterung 7, welche beispielsweise plattenförmig, kalottenförmig oder auch konisch ausgebildet werden kann, wird über die Vakuumdrehdurchführung 6 mit dem Antrieb 5 während den Prozessen gedreht. Die Werkstücke beziehungsweise Substrate 8, wie beispielsweise optische Linsen, insbesondere Kunststofflinsen werden durch die Werkstückhalterung 7 getragen. Die hier konisch dargestellte Werkstückhalterung 7 weist für die Aufnahme der Werkstücke 8 Oeffnungen auf, so dass die Werkstücke 8 beidseitig für den Abscheidevorgang zugänglich sind. Vorteilhaft werden als Werkstückhalterungen auch sogenannte Wendeeinrichtungen eingesetzt. Diese oft segmentförmig geteilten Werkstückhalterungen können dann für die Beschichtung der Rückseite mit Hilfe des Wendemechanismus gedreht werden. Die Bedampfung der Werkstücke 8 erfolgt in bekannter Weise mit Hilfe von Verdampfungsquellen 9, welche in einem gewissen Abstand gegenüber der Werkstückhalterung 7 angeordnet ist. Zur Herstellung gleichförmiger Beschichtungen ist es üblich, solche Verdampfungsgeometrien zu verwenden, wobei wie erwähnt, die Werkstückhalterung 7 mit Hilfe des Antriebes 5 gedreht wird während dem Beschichtungsvorgang. Als Beschichtungsquellen 9 eignen sich besonders die thermischen Verdampfer wie Elektronenstrahlverdampfungsquellen oder auch sogenannte Schiffchenverdampfer. Zur Unterstützung des Aufdampfvorganges können in bekannter Weise über eine Gaseinlass- oder Verteileinrichtung 3 zur Unterstützung der Zusammensetzung der abgeschiedenen Schicht Gase zugeführt werden. Die Zuführung eines oder mehrerer Gase erfolgt über die Anschlussstellen 4. Für die Durchführung des Plasmapolymerisationsprozesses werden über diese Gaseinlassvorichtung 3, 4 die Prozessgase wie Monomere und Hilfsgase eingelassen. Verwendete Prozessgasdrücke bewegen sich je nach den gewünschten Prozessbedingungen im Bereich von 1 Millibar bis 10⁻⁴ Millibar. Für die erfindungsgemässe Durchführung des Verfahrens wird eine Elektrode 10 angeordnet, welche die elektrisch leitende Werkstückhalterung 7 beidseitig teilweise abdeckt und welche mit der Zuleitung 18 über eine isolierte Stromdurchführung 15 mit den elektrischen Speisungen 16, 17 verbunden ist. Die Elektrode 10 ist hierbei so angeordnet, dass sie vom Rand des Werkstückhalters 7 bis etwa zum Drehzentrum reicht. Durch Drehen des Werkstückhalters 7 zwischen den Elektroden 10 hindurch wird sichergestellt, dass die Plasmaentladung, welche sich zwischen der Elektrode 10 und dem als Gegenelektrode wirkenden Werkstückhalter 7 ausbildet, gleichmässig die Werkstücke 8 überstreicht. Der Elektrodenabstand soll sich hierbei in einem Bereich von 1 bis 20 cm bewegen. Qualitativ gute und insbesondere wirtschaftliche Prozessergebnisse werden dann erreicht, wenn die Elektrode 10 ausschliesslich gegen den Werkstückhalter 7 exponiert sind. Hierzu wird die Elektrode 10 auf der dem Werkstückhalter 7 abgewandten Seite mit einer Dunkelraumabschirmung 12, 13 versehen. Diese Dunkelraumabschirmung ist beispielsweise über eine elektrische Verbindung 14 eine mit Masse beziehungsweise Anlagenpotential verbundende elektrisch leitende Potentialfläche, welche einen Abstand gegenüber den Elektroden 10 aufweist, der auf bekannte Weise die Funktion einer Dunkelraumabschirmung sicherstellt und somit vom eingestellten Prozessgasdruck abhängt. Bei dem vorliegenden Verfahren bewegen sich die Abstände im Bereich von einigen Millimetern. Die Zuleitung 18 zu den Elektroden wird vollständig mit Hilfe einer Dunkelraumabschirmung 11 abgeschirmt. Anstelle von solchen Dunkelraumabschirmungen ist auch die Verwendung von Isolatoren wie beispielsweise Keramik möglich.

Zur Erzeugung einer Plasmaentladung wird die Elektrode 10 mit einer elektrischen Spannung von den Generatoren 16, 17 gespiesen. Bei Verwendung eines Gleichspannungsgenerators 16 sind Spannungswerte von 200 Volt bis etwa 5000 Volt möglich. Die Polarität der angeschlossenen Elektrode 10 kann je nach erwünschtem Effekt bezüglich der Struktur der abgeschiedenen Polymerisatschicht gegenüber dem Werkstückhalter 7 negativ oder positiv sein. Der Werkstückhalter ist üblicherweise elektrisch mit der Rezipientenwand verbunden. Dieselbe Anordnung kann auch in bekannter Weise verwendet werden, um vorgängig zum Plamsapolymerisationsabscheidevorgang eine Ionenätzung mit Hilfe einer reinen Edelgasentladung durchzuführen. In so einem Fall kann wahlweise bei negativer Werkstückhalterpolarität das Substrat geätzt werden oder beispielsweise bei positiver Werkstückhalterpolarität mit Elektrodenmaterial bekeimt werden. Anschliessend kann dann ohne Unterbrechung des Prozesses durch Zuführung der entsprechenden Prozessgase der Plasmapolymerisationsprozess ausgeführt werden. Anstelle einer Gleichstromentladung ist es auch möglich, eine Wechselstromentladung zu erzeugen. In so einem Fall wird die Elektrode 10 mit einem Wechselstromgenerator 17 gespiesen. Für die Durchführung des erfindungsgemässen Verfahrens sind Frequenzen von 50 Hertz bis einige Megahertz besonders geeignet. Die Elektrode 10 kann bezüglich dem Werkstückhalter in zwei elektrisch getrennte Teile konzipiert werden welche getrennt mit zwei Generatoren gespiesen werden, was erlaubt, den Prozess fein durch die Einstellung der elektrischen Parameter abzustimmen. In diesem Fall kann es vorteilhaft sein, den Werkstückhalter gegenüber der Kammer 1 isoliert anzuordnen und über eine separate Speisung gegenüber den Elektroden 10 und der Vakuumkammer 1 im sogenannten Bias Betrieb zu betreiben.

Die Effektivität des Verfahrens kann zusätzlich erhöht werden durch Verwendung von Magnetfeldern im Bereich der Plasmaentladung, welche die Plasmadichte erhöht und somit die Abscheiderate erhöht. Die Verwendung von Magnetfeldern kann ausserdem vorteilhaft sein, weil dadurch die Entladespannung erniedrigt wird, welches die Elektrodeninstallation bedeutend vereinfacht und die Verwendung kostengünstigerer Speisungen zulässt. Günstige Ergebnisse werden erreicht wenn Permanentmagnete verwendet werden, welche im Elektrodenbereich angeordnet sind und wenn hierbei eine magnetische Flussdichte im Entladungsbereich zwischen der Elektrode 10 und dem Werkstück 7 von 50 bis 500 Gauss erreicht wird. Mit solchen Anordnungen werden Entladungsspannungswerte von 200 bis 1500 Volt möglich. Die Magnetfelder können selbstverständlich auch mit elektromagnetischen Spulen erzeugt werden.

Figur 2 zeigt eine bevorzugte Ausführungsform im Querschnitt durch die Elektrode 10 und die Dunkelraumabschirmungen 12 und 13 sowie durch den Werkstückhalter 7 mit einem Werkstück 8. Die stabförmige Elektrode 10 mit beispielsweise 10 mm Durchmesser ist in einem Abstand von mehreren Zentimetern gegenüber dem Werkstückträger 7 angeordnet, wobei die Dunkelraumabschirmungen 12 und 13 die Elektrode 10 auf der werkstückabgewandten Seite U-förmig umschliessen. Die Entladung wird auf diese Weise zwischen der Elektrode 10 und der Werkstückhalterung 7 konzentriert. Einerseits wird auf diese Art und Weise die Homogenität des Abscheidevorganges verbessert und andererseits verhindert, dass unzulässige Verunreinigungen, welche bei ausgedehnten Plasmaentladungen aus der Vakuumkammer auf das Substrat niedergeschlagen würde, verhindert.

In gewissen Fällen kann eine flächenförmige Elektrode 10 gegenüber stabförmigen Elektroden vorteilhaft sein. Insbesondere wenn die Dicke der Plasmapolymerisationsschicht gegenüber der Dicke der aufgedampften Schichten im gesamten Verfahren dominiert, hat die Verwendung von einer grossflächigen Elektrode 10 Vorteile. Figur 3 zeigt die Anordnung von einer grossflächigen Elektrode im Querschnitt.

Bei der erfindungsgemässen Anordnung ist eine Flächenabdeckung des Werkstückträgers 7 durch die Elektrode 10 von mehr als 50% nicht mehr wirtschaftlich. Bei grossflächigen Elektrodenanordnungen gemäss Figur 3 kann es notwendig werden, bei höheren Betriebsleistungen die Verlustleistungen mit Hilfe von Kühleinrichtungen 19 abzuführen.

### Beispiel 1

In einer Aufdampfanlage wie beschrieben in Figur 1 wurde eine lackierte und eine nicht lackierte CR 39 Linse mit einer plasmapolymerisierten Schichtkombination versehen und danach mit einer aufgedampften Antireflexentspiegelung beidseitig beschichtet. Zum Aufbringen der Haftschicht wurde eine erfindungsgemässe 12mm dicke stabförmige Elektrode mit einem Abstand zwischen Substrat und Elektrode von 4 cm verwendet. Es wurden folgende Prozessschritte vorgenommen:
- Abpumpen der Anlage bis 1 x 10⁻⁴ mbar.
- Füllen der Anlage mit Dimethyldiaethoxysilan auf einen Druck von 1 x 10⁻¹ mbar.
- Einschalten des DC Generators für die Plasmaentladung mit einer Spannung von 4,2 kV und 160 mA Entladungsstrom während einer Zeit von 60 Sek.
- Abpumpen der Anlage bis 1 x 10⁻⁴ mbar.
- Füllen der Anlage mit Dimethyldiaethoxysilan bis 5 x 10⁻² mbar Druck und anschliessend bis 1 x 10⁻¹ mbar mit Sauerstoff nachgefüllt.
- Anlegen einer Gleichspannung von 4 kV und 140 mA Entladungsstrom während einer Zeit von 60 Sek.

Nach diesen Prozessschritten für die Abscheidung der Polymerisationschicht wurde ohne Unterbrechung des Vakuums die Linse entspiegelt. Die Entspiegelung wurde vorgenommen durch Aufdampfen von 4 Schichten in folgender Reihenfolge TiO₂, SiO₂, TiO₂, SiO₂. Die Entspiegelung der zweiten Linsenseite wurde nach Drehen der Linse mit einer automatischen Wendeeinrichtung auf die gleiche Art und Weise vorgenommen. Dasselbe Verfahren kann auch erfolgreich durchgeführt werden, wenn die Linsen nach der Entspiegelung der ersten Seite manuell nach Oeffnen der Anlage gewendet werden, um die zweite Seite zu entspiegeln.

Die Linsen wurden einem Beständigkeitstest unterworfen, d.h. diese wurden 6 mal in einer kochenden wässrigen 4,5%-igen NaCl-Lösung während 2 Minuten und anschliessend in 20 grädiges Wasser getaucht. Die Schichten zeigten keine sichtbare Beschädigung, wie z.B. Risse oder Ablösungen.

### Beispiel 2

Bei diesem Vesuch wurden die Plasmapolymerisationsschicht und die Antireflexschicht zuerst auf einer Seite aufgebracht und danach auf der anderen Seite der Linse. Für die Abscheidung der Polymerisationsschicht wurde eine einfache stabförmige Elektrode verwendet, wie dies gemäss Stand der Technik üblich ist. Danach wurde die Antireflexschicht aufgedampft. Die Linse wurde dann gewendet, um auf der Rückseite wiederum die Plasmapolymerisationsschicht abzuscheiden und darauf die Antireflexschicht aufzubringen.

Die Linse wurde dem gleichen Test, wie in Beispiel 1 beschrieben, unterworfen. Die Linsenseite, welche zuerst beschichtet worden ist, zeigte die gleiche Beständigkeit wie die beschichteten Linsenseiten gemäss Beispiel 1. Die zweite Linsenseite, die nach dem Wenden beschichtet worden ist, zeigte allerdings bereits nach einem ersten Testzyklus, d.h. nach einmaligem Eintauchen in die wässrige 4,5%-ige NaCl-Lösung, beträchtliche Schichtablösungen. D.h. die zweite Linsenseite zeigt eine völlig unbrauchbare Beschichtung. Ein Vorgehen nach dem bekannten Stand der Technik zur haftfesten beidseitigen Beschichtung von Linsen in der vorliegenden üblichen Anlagenkonfiguration, führt also nicht zu brauchbaren Ergebnissen. Eine Erzeugung von haftfesten Schichten auf beiden Seiten der Linsen wäre gemäss Vorgehen nach Stand der Technik nur möglich, wenn die eine Seite der Linse während der Beschichtung der anderen Seite der Linse abgedeckt würde. Ein solches Vorgehen würde aber erfordern, dass die Linse auf der Rückseite sorgfältig abgedeckt wird. Eine erste Möglichkeit ist, dass nach Behandeln der ersten Seite die Anlage geöffnet wird, die Abdeckung entfernt und die Linse gedreht wird, um die zweite Seite beschichten zu können. Eine zweite Möglichkeit ist die Verwendung einer komplizierten automatischen beweglichen Abdeckvorrichtung, welche vor jedem Wenden der Substrate betätigt werden muss. Eine solche Vorgehensweise oder Vorrichtung ist wirtschaftlich nicht vertretbar und führt wegen der aufwendigen Manipulationen zu einer Qualitätsverminderung der Produkte.

### Beispiel 3

Eine CR 39 Linse wurde wie im Beispiel 1 beschrieben entspiegelt. Nach der Entspiegelung der zweiten Linsenseite wurden ohne Unterbrechung des Vakuums folgende Prozessschritte vorgenommen:
- Füllen der Anlage mit Dimethyldiaethoxysilan bis auf einen Druck von 1.10⁻¹ mbar.
- Einschalten des DC Generators für die Plasamaentladung mit einer Spannung von 4,2 kV und 160 mA Entladungs strom während einer Zeit von 60 Sek.

Beide Seiten der Linse zeigten ein stark hydrophobes Verhalten, das sich durch eine verbesserte Reinigungsfreundlichkeit der Linse bemerkbar machte. Die Linse wurde dem gleichen Test, wie in Beispiel 1 beschrieben, unterworfen. Die Schichten zeigten keine sichtbare Beschädigung, wie z.B. Risse oder Ablösungen.

## Patentansprüche

1. Verfahren zum Beschichten mindestens eines um eine Achse rotierenden Werkstückes (8) in einer Vakuumkammer (1) mittels einer Plasmaentladung zur Abscheidung einer Polymerisatschicht und durch thermisches Verdampfen, dadurch gekennzeichnet, dass die Polymerisatschicht gleichzeitig auf beiden Seiten des Werkstückes (8) abgeschieden wird, und dass anschliessend thermisch aufgedampfte Schichten auf die beiden Seiten des Werkstückes (8) aufgebracht werden, indem zuerst eine Seite beschichtet wird und danach das Werkstück gewendet und auf der anderen Seite beschichtet wird.

2. Verfahren nach Anspruch 1, dadurch gekenzeichnet, dass das Beschichten ohne Vakuumunterbrechung erfolgt und das Aufbringen der aufgedampften Schichten auf beiden Seiten durch Wenden des Werkstückes (8) in der Vakuumkammer (1) erfolgt.

3. Verfahren nach Anspruch 1 oder 2, dadurch gekennzeichnet, dass mehr als zwei Schichten aufgebracht werden.

4. Verfahren nach Anspruch 3, dadurch gekennzeichnet, dass zuerst eine Polymerisatschicht, dann mindestens eine thermisch aufgedampfte Schicht und als Deckschicht eine Polymerisatschicht abgeschieden wird.

5. Verfahren nach Anspruch 1 bis 4, dadurch gekennzeichnet, dass für die plasmapolymerisierende Schichtabscheidung monomere Gase von organischen oder metallorganischen Verbindungen verwendet werden, und dass für die Aufbringung der aufgedampften Schichten Metalle oder Metallverbindungen der Oxyde, Fluoride, Sulfide, Telluride und Selenide verdampft werden.

6. Verfahren nach Anspruch 1 bis 5, dadurch gekennzeichnet, dass für die plasmapolymerisierende Schichtabscheidung monomere Gase von siliziumorganischen Verbindungen verwendet werden, und dass für die Aufbringung der aufgedampften Schichten Metalle oder Metallverbindungen der Oxyde, Fluoride, Sulfide, Telluride und Selenide verdampft werden.

7. Verfahren nach Anspruch 5 oder 6, dadurch gekennzeichnet, dass für die Plasmaentladung den polymerisierbaren Gasen Zusatzgase beigemischt werden wie O₂, Ar, Luft, H₂, H₂O, N₂, NO, NO₂ und/oder He.

8. Verfahren nach Anspruch 1 bis 7, dadurch gekennzeichnet, dass Magnetfelder zur Erhöhung der Plasmadichte verwendet werden.

9. Verfahren nach Anspruch 1 bis 8, dadurch gekennzeichnet, dass die Schichten auf ophtalmische Linsen abgeschieden werden.

10. Beschichtungsvorrichtung zur Beschichtung mindestens eines Werkstückes (8), dadurch gekennzeichnet, dass sie umfasst:
- eine Vakuumkammer (1) mit einer Pumpeinrichtung(2) und einer Gaseinlassvorrichtung (4,3);
- einen um eine Achse rotierbaren elektrisch leitenden Werkstückträger (7).
- mindestens eine in Achsrichtung beidseitig der Werkstückträger-Bahn angeordnete, diese mindestens teilweise abdeckende Glimmelektrode (10)
- mindestens eine thermische Verdampfungsquelle (9) sowie
- eine Stromversorgung (16, 17) zur Erzeugung einer Plasmaentladung zwischen der Glimmelektrode (10) und dem Werkstückträger (7).

11. Beschichtungsvorrichtung nach Anspruch 10, zur Beschichtung des Werkstückes (8) nach dem Verfahren nach einem der Ansprüche 1 bis 9.

12. Beschichtungsvorrichtung nach Anspruch 10 oder 11, dadurch gekennzeichnet, dass die Elektrode (10) höchstens die Hälfte des Werkstückträgers abdeckt.

13. Beschichtungsvorrichtung nach Anspruch 12, dadurch gekennzeichnet, dass elektrische Zuleitungen (18) im wesentlichen vollständig und die Glimmelektroden (10) auf der dem Werkstück abgewandten Seite, mit einer Dunkelraumabschirmung (11,12,13) und/oder mit Isolatoren abgedeckt sind.

14. Verwendung der Beschichtungsvorrichtung nach Anspruch 10 bis 13 zur Beschichtung von ophtalmischen Linsen, vorzugsweise nach einem Verfahren gemäss den Ansprüchen 1 bis 9.

## Claims

1. Method to coat at least one substrate (8) rotating around an axis within a vacuum chamber (1) by means of a plasma discharge to deposit a polymerisation film and by means of thermic evaporation, characterized in that the polymerisation film is deposited at the same time on both sides of the substrate (8) and that subsequently thermically evaporated films are deposited onto both sides of the substrate (8) whereby one side is first coated and the other side is coated after the substrate was turned.

2. Method as claimed in claim 1 characterized in that the coating is done without interrupting the vacuum and the evaporation of the films on both sides of the substrate takes place by turning the substrate (8) within the vacuum chamber (1).

3. Method as claimed in claim 1 or 2 characterized in that more than two films are deposited.

4. Method as claimed in claim 3 characterized in that the deposition takes place in the following order: first a polymerisation film, then at least one thermically evaporated film and a polymerisation coating functioning as cover coating.

5. Method as claimed in claim 1 through 4 characterized in that for the plasma polymerizing film deposition monomere gases of organic or metal-organic compounds are used and that for the deposition of the evaporated coatings metals or metal compounds of oxydes, fluorides, sulfides, tellurides and selenides are evaporated.

6. Method as claimed in claim 1 through 5 characterized in that for the plasma polymerizing film deposition monomere gases of silicon-organic compounds are used and that for the deposition of the evaporated coatings metals or metal compounds of oxydes, fluorides, sulfides, tellurides and selenides are evaporated.

7. Method as claimed in claim 5 or 6 characterized in that for the plasma discharge additional gases are added to the polymerizeable gases such as O₂, Ar, air, H₂_{,} H₂O, N₂, NO, NO₂ and/or He.

8. Method as claimed in claim 1 through 7 characterized in that magnetic fields are used to increase the plasma density.

9. Method as claimed in claim 1 through 8 characterized in that the coatings are deposited on ophtalmic lenses.

10. Coating device to coat at least one substrate (8) characterized in that said device consists of:
- a vacuum chamber (1) with a pumping device (2) and a gas inlet arrangement (4,3);
- an electrically conducting substrate carrier (7) which can rotate around an axis;
- at least one glowing electrode (10) placed in axis direction on both sides of the substrate carrier course said electrode covering this course at least partially;
- at least one thermic evaporation source (9) as well as
- a power supply (16,17) to generate a plasma discharge between the glowing elctrode (19) and the substrate carrier (7).

11. Coating device as claimed in claim 10 to coat the substrate (8) according to the method as of one of the claims 1 through 9.

12. Coating device as claimed in claim 10 or 11 characterized in that the electrode (10) covers maximally half of the substrate carrier.

13. Coating device as claimed in claim 12 characterized in that the supplying electric conductors (18) mainly are covered entirely and the glowing electrodes (10) on the side turned away from the substrate are covered by means of a dark space shield (11,12,13) and/or by insulators.

14. Use of said coating device as of claim 10 through 13 to coat ophtalmic lenses preferably according to a method as claimed in claims 1 through 9.

## Revendications

1. Procédé de revêtement d'au moins une pièce à traiter (8), tournant autour d'un axe dans une chambre de vide (1), au moyen d'une décharge plasma destinée à déposer une couche de polymérisat et au moyen d'une évaporation thermique, caractérisé en ce que la couche de polymérisat est déposée simultanément sur les deux côtés de la pièce à traiter (8) et que des couches déposées par évaporation thermique sont ensuite appliquées sur les deux côtés de la pièce à traiter (8), un premier côté étant revêtu en premier lieu, la pièce à traiter étant ensuite tournée et le deuxième côté étant ensuite revêtu.

2. Procédé selon la revendication 1, caractérisé en ce que le revêtement s'effectue sans interruption de vide et que l'application des couches appliquées par évaporation sur les deux côtés se produit par rotation de la pièce à traiter (8) dans la chambre de vide (1).

3. Procédé selon la revendication 1 ou 2, caractérisé en ce que le nombre des couches appliquées est supérieur à deux.

4. Procédé selon la revendication 3, caractérisé en ce qu'une première couche de polymérisat est déposée en premier lieu et qu'au moins une couche déposée par évaporation thermique et une couche de polymérisat qui sert de couche de protection sont ensuite déposées.

5. Procédé selon l'une des revendications 1 à 4, caractérisé en ce que des gaz monomères venant de composés organiques ou organométalliques sont utilisés pour le dépôt de couches qui se polymérisent par plasma et que des métaux ou des composés métalliques des oxydes, fluorures, sulfures, tellurures et séléniures sont évaporés pour l'application des couches appliquées par évaporation.

6. Procédé selon l'une des revendications 1 à 5, caractérisé en ce que des gaz monomères venant de composés organo-siliciques sont utilisés pour le dépôt de couches qui se polymérisent par plasma et que des métaux ou des composés métalliques des oxydes, fluorures, sulfures, tellurures et séléniures sont évaporés pour l'application des couches appliquées par évaporation.

7. Procédé selon la revendication 5 ou 6, caractérisé en ce que des gaz additionnels, par exemple O₂, Ar, de l'air, H₂, H₂0, N₂, NO, NO₂ et/ou He sont ajoutés pour la décharge plasma des gaz polymérisables.

8. Procédé selon l'une des revendications 1 à 7, caractérisé en ce que des champs magnétiques sont utilisés pour élever la densité de plasma.

9. Procédé selon l'une des revendications 1 à 8, caractérisé en ce que les couches sont déposées sur des lentilles ophtalmiques.

10. Installation de revêtement destiné à revêtir au moins une pièce à traiter (8), caractérisé en ce qu'il comprend:
- une chambre de vide (1) pourvue d'une installation de pompe (2) et d'une installation d'introduction de gaz (4, 3);
- un support (7) de pièce à traiter électriquement conducteur tournant autour d'un axe;
- au moins une électrode électroluminescente (10) disposée en direction axiale sur les deux côtés de la voie de support de pièce à traiter et recouvrant au moins partiellement cette voie;
- au moins une source d'évaporation thermique (9), ainsi que
- une alimentation en courant (16, 17) pour engendrer une décharge plasma entre l'électrode électroluminescente (10) et le support (7) de pièce à traiter.

11. Installation de revêtement selon la revendication 10 destinée à revêtir la pièce à traiter (8) selon le procédé conforme à l'une des revendications 1 à 9.

12. Installation de revêtement selon la revendication 10 ou 11, caractérisée en ce que l'électrode (10) recouvre au maximum la moitié du support de pièce à traiter.

13. Installation de revêtement selon la revendication 12, caractérisée en ce qu'un écran d'espace sombre (11, 12, 13) et/ou des isolants recouvrent sensiblement en totalité des lignes électriques (18) et recouvrent les électrodes électroluminescentes (10) sur le côté opposé à la pièce à traiter.

14. Utilisation du dispositif de revêtement selon l'une des revendications 10 à 13 pour le revêtement de lentilles ophtalmiques, de préférence selon un procédé conforme aux revendications 1 à 9.
